(19) Europäisches Patentamt European Patent Office Office européen des brevets

(11) **EP 4 646 044 A1**

(12) **EUROPEAN PATENT APPLICATION**

(43) Date of publication:
**05.11.2025 Bulletin 2025/45**

(21) Application number: **24173082.9**

(22) Date of filing: **29.04.2024**

(51) International Patent Classification (IPC):
*H05K 7/20* (2006.01)    *G06F 1/20* (2006.01)
*G06F 1/3206* (2019.01)    *G06F 1/3234* (2019.01)

(52) Cooperative Patent Classification (CPC):
**H05K 7/20836; G06F 1/20; G06F 1/3206;
G06F 1/3234**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Vertiv S.r.l.**
**35028 Piove di Sacco, (PD) (IT)**

(72) Inventors:
• **TAKACS, Balint**
  **Galanta (SK)**
• **BARBATO, Pierpaolo**
  **Noventa Padovana (IT)**
• **VOIGT, Tyler William**
  **Delaware (US)**

(74) Representative: **Beal, James Michael et al**
  **Kilburn & Strode LLP**
  **Lacon London**
  **84 Theobalds Road**
  **London WC1X 8NL (GB)**

(54) **OPTIMISING OPERATION OF COOLING UNITS**

(57) A method for optimising operation of a plurality of cooling units, a control device, a cooling system and a computer readable medium are provided. The method comprises obtaining a current energy consumption of a first configuration of the plurality of cooling units in which a first number of the plurality of cooling units are active. The method further comprises determining a predicted energy consumption of a second configuration of the plurality of cooling units in which a second number of the plurality of cooling units are active, and in which one or more of the second number of the plurality of cooling units operates in an altered mode of operation relative to the first configuration. The method further comprises generating, in response to determining that the predicted energy consumption is lower than the current energy consumption, a computer-executable instruction configured to cause the plurality of cooling units to operate according to the second configuration.

300

| 302 |
| --- |
| Obtain a current energy consumption of a first configuration of a plurality of cooling units in which a first number of the plurality of cooling units are active |

| 304 |
| --- |
| Determine a predicted energy consumption of a second configuration of the plurality of cooling units in which a second number of the plurality of cooling units are active, and in which one or more of the second number of the plurality of cooling units operates in an altered mode of operation relative to the first configuration |

| 306 |
| --- |
| Generate, in response to determining that the predicted energy consumption is lower than the current energy consumption, a computer-executable instruction configured to cause the plurality of cooling units to operate according to the second configuration |

Fig. 3

EP 4 646 044 A1

## Description

This disclosure relates to a method for optimising operation of a plurality of cooling units, a control device, a cooling system and a computer-readable medium.

Background

In a data centre, servers and other computational equipment can generate a large amount of heat, and typically need to be cooled to prevent overheating. This is important because many industries and various critical infrastructure rely on data centres to operate reliably without interruption. In data centres, as well as other settings, a cooling system can remove excess heat from the air in order to cool the air. This helps regulate the environment in which the servers are housed and therefore helps maintain their continuous, efficient operation.

In typical data centres with air-cooled racks, a large proportion of the power consumption is expended on providing cooling. As such, the energy efficiency of the cooling system can have a big impact on the energy efficiency of the data centre as a whole. It is desirable to lower the energy consumption of data centres in order to reduce costs and emissions associated with energy generation, transmission and use. As such, it would be desirable to reduce the energy consumption of cooling systems.

A cooling system may include a plurality of cooling units configured to cool the air of the data centre through removing heat from this air and transferring the heat out of the data centre. Redundancy may be provided in the cooling units through providing a greater number of cooling units that is expected to be needed for cooling the data centre. In other words, the total possible cooling capacity of the cooling system may exceed the cooling needed for the data centre. This may enable one or more of the cooling units to be turned off or serviced while adequate cooling is maintained. In addition, the cooling it is required to deliver may vary based on activity of the servers of the data centre and based on ambient temperature, i.e. the temperature in the external environment at a given time. Providing redundancy may provide flexibility for providing the required cooling even when the external temperature is very high.

A known cooling unit may include a compressor configured to increase the pressure of refrigerant in a refrigerant circuit, and may also include a pump configured to move the refrigerant around the refrigerant circuit. Both of the compressor and the pump may be described as refrigerant circulating devices. The cooling unit may be operated in compressor mode, in which the compressor is active and the pump is inactive, or in pump mode in which the pump is active and the compressor is inactive. Some cooling units comprising two (or more) cooling circuits may also operate in a mixed mode in which, in a first of the cooling circuits, a compressor is active and a pump is inactive, and, in a second of the cooling circuits, a pump is active and a compressor is inactive.

Operation in pump mode can be implemented using a pump refrigerant economizer, and such operation consumes less energy than operation in compressor mode. However, operation in pump mode is only suitable for providing cooling if the ambient temperature is relatively low. Compressor mode operation, or mixed mode operation, may be required to provide cooling if ambient temperatures are higher.

For a cooling system with redundancy or that is otherwise operating at less than full capacity, there are a large number of permutations of which cooling units are operated and in which mode they are operated in. These different permutations may lead to different levels of energy consumption. If a required cooling is adequately delivered by a particular permutation, this permutation may be maintained since the cooling system is operating to meet the demand placed on it. Moreover, if there are changes to the ambient air temperature or the required cooling, the present permutation may no longer be optimal, and further options for operating the cooling system are opened up.

It would be desirable to provide a more energy efficient cooling system including a plurality of cooling units. In addition, it would be desirable to provide more dynamic and/or more responsive operation of a cooling system comprising a plurality of cooling units.

The present invention seeks to address these and other disadvantages encountered in the prior art.

Summary

An invention is set out in the independent claims.

According to an aspect, there is provided a method for optimising operation of a plurality of cooling units, the method comprising: obtaining a current energy consumption of a first configuration of the plurality of cooling units in which a first number of the plurality of cooling units are active; determining a predicted energy consumption of a second configuration of the plurality of cooling units in which a second number of the plurality of cooling units are active, and in which one or more of the second number of the plurality of cooling units operates in an altered mode of operation relative to the first configuration; and generating, in response to determining that the predicted energy consumption is lower than the current energy consumption, a computer-executable instruction configured to cause the plurality of cooling units to operate according to the second configuration.

According to a further aspect, there is provided a control device comprising a processor and a memory storing computer-executable instructions, the instructions when executed causing the processor to perform the above-mentioned method.

According to a further aspect, there is provided a cooling system comprising: the above-mentioned control device; and the plurality of cooling units.

According to a further aspect, there is provided a computer-readable medium storing instructions which, when executed by a processor, cause performance of the above-mentioned method.

Brief Description of the Drawings

Specific embodiments are now described, by way of example only, with reference to the drawings, in which:

Figure 1 depicts an example cooling unit according to the present disclosure;
Figure 2 depicts an example cooling system according to the present disclosure;
Figure 3 depicts an example method for optimising operation of a plurality of cooling units according to the present disclosure;
Figure 4 depicts a further example method for optimising operation of a plurality of cooling units according to the present disclosure;
Figure 5 depicts a further example method for optimising operation of a plurality of cooling units according to the present disclosure;
Figure 6 depicts an example computing device according to the present disclosure.

Detailed Description

The present invention provides a method for optimising operation of a plurality of cooling units. The method includes obtaining a current energy consumption of a first configuration of the plurality of cooling units in which a first number of the plurality of cooling units are active. In the first configuration, some of the plurality of cooling units may be active (i.e. providing cooling) and some may be inactive (i.e. not providing cooling/in standby mode). In the first configuration, each of the active cooling units may be operating in a respective operating mode, which may be the same or different. The operating modes may be selected from a compressor mode, a pump mode and a mixed compressor and pump mode.

The method includes determining a predicted energy consumption of a second configuration of the plurality of cooling units in which a second number (which may be different to the first number) of the plurality of cooling units are active. In the second configuration, one or more of the second number of the plurality of cooling units operates in an altered mode of operation relative to the first configuration. In other words, relative to the first configuration, in the second configuration the number of active cooling units can be different and at least one of the cooling units can operate in a different mode (again selected from the compressor mode, the pump mode and the mixed compressor and pump mode). By way of example, in the second configuration one or more additional cooling units may be active relative to the first configuration, and some or all of the active cooling units may operate in pump mode or mixed compressor and pump mode whereas the active cooling units in the first configuration may operate in compressor mode.

The method includes generating, in response to determining that the predicted energy consumption is lower than the current energy consumption, a computer-executable instruction configured to cause the plurality of cooling units to operate according to the second configuration. If the predicted energy consumption is lower than the current energy consumption, i.e. if the second configuration would consume less energy than the first configuration is consuming, then switching operation to the second configuration can lower the energy consumption of the cooling system and therefore provide more optimised, more energy efficient operation.

These techniques therefore enable more dynamic and responsive operation of the cooling system through identifying and reacting to opportunities to lower energy consumption of the cooling system, including those that result from changes to the ambient temperature or to the cooling required for a data centre at a particular time. In this manner, these techniques enable provision of a more energy efficient cooling system.

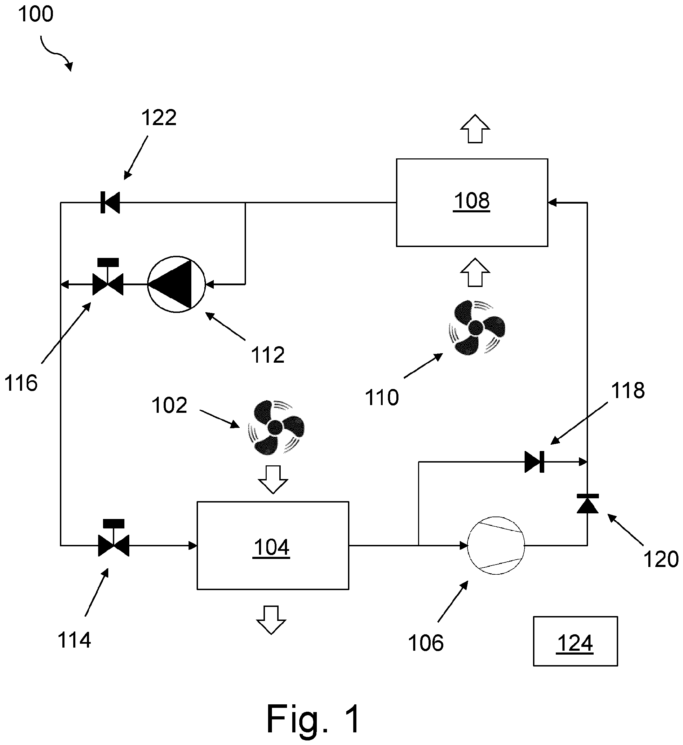

Figure 1 depicts an example of a cooling unit 100 according to the present disclosure. A cooling unit (which may also be referred to as a cooling delivery unit) is configured to absorb heat from a given space (for example as generated by servers in a data centre) and transfer it outside of the space, for example to an outside environment where the heat is released. The techniques of the present disclosure are applicable to all cooling units and cooling systems. The cooling unit 100 of Figure 1 may be an air handling unit with one circuit, for ease of explanation, though the techniques of the present disclosure are not limited thereto.

The cooling unit 100 may be divided into two parts, which may be referred to as an air circuit and a refrigerant circuit respectively. The air circuit is configured to move hot air by sucking the hot air from the servers into the cooling unit 100 and supplying the same air with a lower temperature back to the servers. This may be performed using fans. The air is represented in Figure 1 using block, vertical arrows pointing upwards and downwards. In Figure 1, refrigerant is passed in a generally anti-clockwise direction in one or more pipes or conduits represented using a series of consecutive arrows arranged in a ring/rectangle.

This may be referred to as the refrigerant circuit. The refrigerant circuit is configured to circulate refrigerant to cool down the air of the air circuit. The refrigerant used in the refrigerant circuit may be water, a water-glycol mixture, fluorinated gases (F-gases) or natural gases such as carbon dioxide or propane. As would be understood by the skilled person, the refrigerant may be a mixture of gases such as R410A or R1234ze. Phase changing refrigerants will be focused on below for ease of understanding, though the present disclosure is not limited thereto.

The refrigerant circuit is a closed circuit in which the same refrigerant circulates while it changes its physical properties such as pressure, temperature and state (liquid or gas). An evaporator fan 102 is configured to move hot air from one or more servers and their surroundings to the evaporator coil 104 (also referred to herein as an evaporator). The hot air passes across the evaporator 104 and is cooled down as the refrigerant absorbs the heat. This occurs without mixing of the air and the refrigerant. The cooler air can then be recirculated to the one or more servers to absorb further heat.

During the heat absorption, the state of the refrigerant changes from liquid to gas. Subsequently, when the cooling unit is operating in compressor mode (discussed in more detail below), this refrigerant gas may be sucked into the compressor 106. The compressor 106 is configured to increase the pressure of the refrigerant by compressing it into a smaller volume and to transfer it to the condenser 108. A condenser fan 110 is configured to circulate cool air across the condenser 108 in order to cool the refrigerant until it condensates (changes state from gas to liquid). The condenser 108 may be located outside, i.e. not within buildings making up the data centre. The liquid refrigerant is then fed back towards the evaporator 104 for absorbing heat from further hot air.

The cooling unit comprises a pump 112 located in the refrigerant circuit between the evaporator 104 and the condenser 108. The pump is configured to pump, drive or impel refrigerant around the refrigerant circuit. When the cooling unit 100 is operating in pump mode (discussed in more detail below), the pump moves the refrigerant around the refrigerant circuit towards the evaporator 104.

The cooling unit 100 may comprise one or more expansion valves 114, 116, such as electronic expansion valves (EEV). These are configured to control the amount of refrigerant that flows therethrough. The cooling unit may also comprise one or more check valves 118, 120, 122. These may be configured to allow the refrigerant to flow in one direction (the anti-clockwise direction in Figure 1) but not in the reverse direction (the clockwise direction in Figure 1). The cooling unit 100 may comprise a controller 124. The controller 124 may be communicatively coupled to any one, multiple or all of the other components of the cooling unit 100 and be configured to send control signals thereto to alter their operation and/or to receive data signals therefrom. The controller may be configured to process the data signals to determine the control signals. The cooling unit 100 may comprise one or more sensors, such as one or more pressure sensors and/or temperature sensors, at different points of the refrigerant circuit. These may be configured to determine and communicate the pressure/temperature/other parameters of the refrigerant at the respective points of the refrigerant circuit, e.g. to communicate them to the controller 124.

As referred to above, the cooling unit 100 may be active (providing cooling) or inactive (not providing cooling). When it is active, the cooling unit 100 may operate in compressor mode, pump mode or mixed compressor and pump mode.

In the compressor mode, the refrigerant is passed through the compressor 106. This may be achieved, for example, by controlling a valve in series with the compressor 106 (e.g. check valve 120) to be open and controlling a valve in parallel with the compressor 106 (e.g. check valve 118) to be closed. In other words, the refrigerant passes through the compressor 106 and the check valve 120, but not through the check valve 118. In the compressor mode, refrigerant is not passed through the pump 112. This may be achieved, for example, by controlling a valve in series with the pump 112 (e.g. expansion valve 116) to be closed and controlling a valve in parallel with the pump 112 (e.g. check valve 122) to be open. In other words, the refrigerant passes through the check valve 122, but not through the pump 112 or the expansion valve 116. The controller 124 of the cooling unit 100 communicatively coupled to the above-mentioned valves may be configured to transmit control signals to the above-mentioned valves to open and close them as needed. The controller 124 may be communicatively coupled to the compressor 106 and the pump 112 and may be configured to send control signals to these components respectively configured to turn the compressor 106 on and the pump 112 off in compressor mode.

In the pump mode, the refrigerant is passed through the pump 112. This may be achieved, for example, by controlling a valve in series with the pump 112 (e.g. expansion valve 116) to be open and controlling a valve in parallel with the pump 112 (e.g. check valve 122) to be closed. In other words, the refrigerant passes through the pump 112 and the expansion valve 116, but not through the check valve 122. In the pump mode, refrigerant is not passed through the compressor 106. This may be achieved, for example, by controlling a valve in series with the compressor 106 (e.g. check valve 120) to be closed and controlling a valve in parallel with the compressor 106 (e.g. check valve 118) to be open. In other words, the refrigerant passes through the check valve 118, but not through the compressor 106 or the check valve 120. The controller 124 of the cooling unit 100 communicatively coupled to the above-mentioned valves may be configured to transmit control signals to the above-mentioned valves to open and close them as needed. The controller 124 may be communicatively coupled to the compressor 106 and the pump 112 and may be configured to send control signals to these components respectively configured to turn the compressor 106 off and the pump 112 on in pump mode.

Operating in pump mode is more energy efficient than operating in compressor mode because the pump increases the pressure of the refrigerant much less than the compressor does. The pressure difference between the high pressure and low pressure sides of the refrigerant circuit in pump mode may, by way of example, be as low as 1-2 bars. In contrast, the pressure difference between the high pressure and low pressure sides in compressor mode may, by way of example, reach a magnitude of 10 bars. As such, pump mode uses less energy than compressor mode. However, providing adequate cooling in pump mode may only be possible for relatively low ambient temperatures, while providing adequate cooling in compressor mode may also be possible for operation in relatively high ambient temperatures. For the relatively low ambient temperatures, the outdoor ambient air may be used to cool the refrigerant directly without need for the compressor 106 to be active. This may not be possible for higher temperatures in which the ambient air is too warm to provide effective cooling.

The cooling unit 100 may also operate in mixed mode, using a combination of compressor and pump. For example, while a cooling unit 100 with a single refrigerant circuit, compressor 106 and pump 112 is depicted in Figure 1 for ease of explanation, a cooling unit 100 as described herein may comprise two, three or more of each of these components. For example, for a cooling unit with two refrigerant circuits, each with a respective compressor 106 and pump 112, in the mixed mode only one of the compressors 106 and one of the pumps 112 may be active.

For a cooling unit 100 with two refrigerant circuits as described above, in the compressor mode both refrigerant circuits could operate in compressor mode, or one of the refrigerant circuits could operate in compressor mode and the other could be inactive. For the cooling unit 100 with two refrigerant circuits operating in pump mode, both refrigerant circuits could operate in pump mode, or one of the refrigerant circuits could operate in pump mode and the other could be inactive. For the cooling unit with two refrigerant circuits operating in mixed mode, one of the refrigerant circuits could operate in compressor mode and the other could operate in pump mode.

The mixed mode may be suitable for moderate ambient temperatures between the relatively high and relatively low ambient temperatures referred to above. In the mixed mode, the refrigerant may be 'precooled' through transferring heat to the outside air such that less cooling is required by way of the action of the compressor 106.

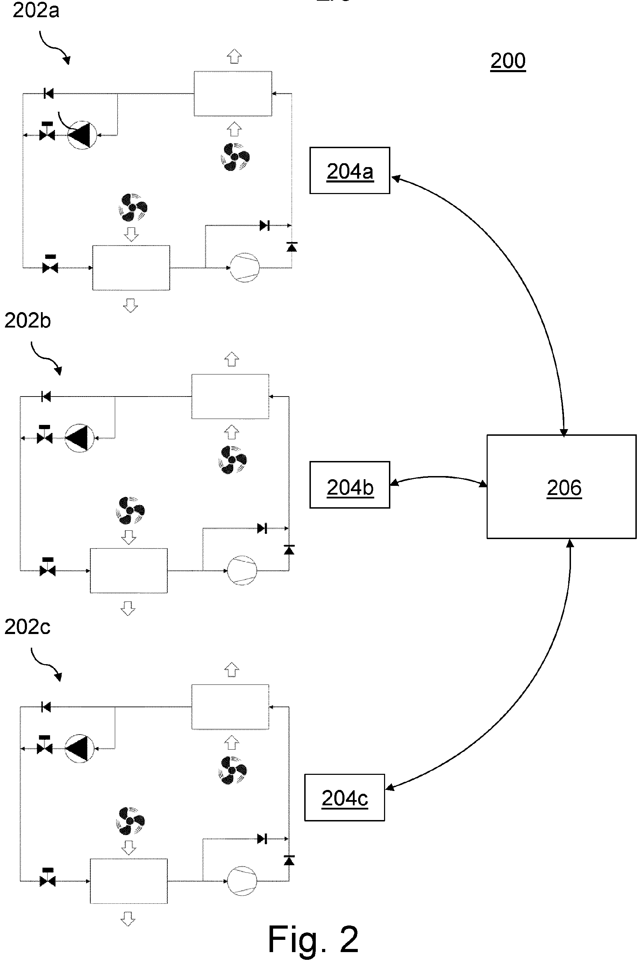

Figure 2 depicts an example cooling system 200 according to the present disclosure. The cooling system 200 comprises a plurality of cooling units 202a, 202b, 202c. Each of the cooling units 202a, 202b, 202c may correspond to the cooling unit 100 of Figure 1. While three cooling units 202a, 202b, 202c are considered in Figure 2 for ease of illustration and explanation, it will be appreciated that the cooling system 200 may comprise any number of cooling units, such as two, three, four, five, six, seven, eight, nine, ten or more cooling units.

Each of the cooling units 202a, 202b, 202c may comprise a respective cooling unit controller 204a, 204b, 204c. The cooling unit controllers 204a, 204b, 204c may each correspond to the controller 124 of Figure 1. The cooling unit controllers 204a, 204b, 204c may be referred to as control devices or local controllers herein. Each of the cooling unit controllers 204a, 204b, 204c may be communicatively coupled to one, multiple or all of the components of the respective cooling unit 202a, 202b, 202c. Each cooling unit controller 204a, 204b, 204c may be configured to transmit control signals to respective components of the respective cooling unit 202a, 202b, 202c, in order to adjust the operation of the respective cooling unit 202a, 202b, 202c. Alternatively, or in addition, each cooling unit controller 204a, 204b, 204c may be configured to receive data from respective components of the respective cooling unit 202a, 202b, 202c. The data may comprise a parameter of the cooling unit 202a, 202b, 202c describing the state of components of the cooling unit 202a, 202b, 202c or physical parameters of the refrigerant or air of the cooling unit 202a, 202b, 202c. Alternatively, or in addition, the data may comprise information enabling calculation or determination of such a parameter, for example as performed by the respective cooling unit controller 204a, 204b, 204c.

The cooling system 200 may comprise a cooling system controller 206. The cooling system controller 206 may be referred to as a control device or global controller or supervisory system herein. The cooling system controller 206 may be communicatively coupled to each of the cooling units 202a, 202b, 202c. For example, the cooling system controller 206 may be communicatively coupled to each of the cooling unit controllers 204a, 204b, 204c. For example, this may comprise the cooling system controller 206 transmitting the control signals described above and/or receiving the data described above. The cooling system controller 206 may perform the calculation or determination of parameters as described above.

The use of a cooling system 200 comprising a plurality of cooling units 202a, 202b, 202c is advantageous as it provides redundancy in case of a fault or reduced/halted operation of a particular one of the cooling units 100. This enables reduced downtime and a higher level of reliability of the cooling system 200 and of the data centre it is configured to cool.

The use of a cooling system controller 206 communicatively coupled to each of the cooling units 202a, 202b, 202c enables prevention of individual cooling units 202a, 202b, 202c from operating in a conflicting manner (e.g. with one of the units humidifying the air while another is dehumidifying the air), in particular when the cooling units 202a, 202b, 202c are in the same room. Such coordinated (or 'teamwork') operation of the plurality of cooling units 100 can save electrical energy and reduce potential control instability issues (e.g. activation/deactivation of individual cooling units 202a, 202b, 202c). In such coordinated operation, the total cooling load required can be distributed across the cooling units 202a, 202b, 202c as appropriate, which may enable more stable and reliable operation from a control quality perspective.

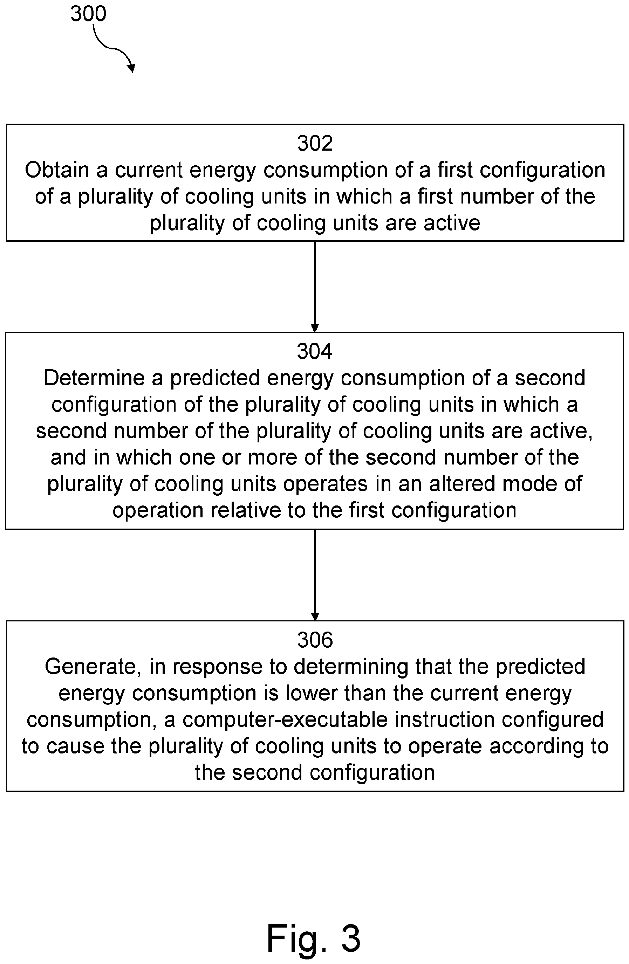

Figure 3 depicts an example method 300 for optimising operation of a plurality of cooling units according to the present disclosure. The method 300 may be performed by the system controller 206. The method 300 may be performed by one of the cooling unit controllers 204a, 204b, 204c, for example a one of the cooling unit controllers 204a, 204b, 204c which is designated a master cooling unit controller. The controller 206, 204a, 204b, 204c may comprise a processor and a memory storing computer-executable instructions, the instructions when executed causing the processor to perform the method 300. The instructions may be stored in a computer-readable medium.

In a step 302, the method 300 comprises obtaining a current energy consumption of a first configuration of a plurality of cooling units in which a first number of the plurality of cooling units are active.

The step 302 may comprise determining the current energy consumption through calculation, estimation or based on look-up tables. The step 302 may comprise measuring the current energy consumption, for example using a power meter coupled to an electrical supply to the cooling system. The step 302 may comprise receiving the current energy consumption from an external source or processor.

In a step 304, the method 300 comprises determining a predicted energy consumption of a second configuration of the plurality of cooling units in which a second number of the plurality of cooling units are active, and in which one or more of the second number of the plurality of cooling units operates in an altered mode of operation relative to the first configuration. The mode(s) of operation in the first configuration and the second configuration (i.e. including the altered mode of operation) may be selected from the pump mode of operation, the compressor mode of operation and the mixed pump and compressor mode of operation.

The second number of the plurality of cooling units active in the second configuration may be greater than the first number of the plurality of cooling units active in the first configuration. The second number of the plurality of cooling units active in the second configuration may be less than the first number of the plurality of cooling units active in the first configuration.

The determining of the predicted energy consumption may comprise determining, for each of a plurality of candidate second configurations, a respective predicted energy consumption. Each of the plurality of candidate second configurations may have a different respective number of the plurality of cooling units active and/or a different respective altered mode of operation. It may be determined which of the plurality of candidate second configurations has a smallest predicted energy consumption and the candidate second configuration with the smallest predicted energy consumption may be selected as the second configuration. This may further increase energy efficiency through consideration of many different possible configurations and selecting a most energy efficient configuration. The plurality of candidate second configurations and the respective predicted energy consumptions may be stored in a database. This may enable this data to be reused for subsequent iterations of the method 300 without requiring full recalculation of this data, which may provide more computationally efficient implementation of the method 300.

The determining of the predicted energy consumption may be based on a current ambient temperature. The determining of the predicted energy consumption may be based on a required level of cooling or a cooling capacity of the cooling system. As described above, different modes of operation may be suitable for different ambient temperatures. The energy efficiency of different configurations may vary depending on the current ambient temperature and the level of cooling required.

The predicted energy consumption may be based on one or more measurements received from the cooling units, such as temperatures, pressures, ramping, opening, etc. The system controller 206, or another component, may receive these parameters and based on these may calculate the cooling capacity of each of the cooling units. The system controller 206, or another component, may receive a current ambient temperature from an external temperature sensor. Based on the cooling capacity and ambient temperature, the system controller 206, or another component, may predict the energy consumption of each of the cooling units.

Determining the predicted energy consumption may comprise accessing a database or look-up table comprising a plurality of scenarios comprising previously measured energy consumptions (i.e. experimental data). These previously measured energy consumptions may be associated in the database or look-up table with one or more of the number of cooling units that were active, the mode(s) they were operating in, the ambient temperature, and the cooling required. It may be determined which scenario is closest to the second configuration (with the corresponding number of active units and operating mode(s)), to the current ambient temperature, and to the current cooling requirements. If the scenario has a corresponding configuration (with the same number of active units and the same operating mode(s)), and an ambient temperature which is within a threshold of the current ambient temperature (and optionally a required cooling which is within a second threshold of the required cooling), the measured energy consumption associated with that scenario may be selected as the predicted energy consumption of the second configuration.

As would be appreciated by the skilled person, determining of the predicted energy consumption may include generation of the predicted energy consumption based on one or more rating tools as used in the industry, for example one or more rating tool(s) specific to the model of cooling units used in the data centre. These determinations may be supplemented with lab and field data for this model of cooling units.

Determining the predicted energy consumption may comprise extrapolating from current and previous energy consumption based on current and previous operation of the cooling units. For example, trend lines or fitting tools may be used to predict the energy consumption as a function of ambient temperature and/or required cooling.

Determining the predicted energy consumption may comprise generating, creating or providing one or more mathematical models or functions, which takes inputs such as cooling capacity and ambient air temperature. These functions may have a predefined format and predefined parameters such that real-time determining of the predicted energy consumption may merely comprise evaluation of the output of this function based on the provided inputs. By way of example for ease of illustration, a function may take the form predicted energy consumption = a*(ambient temperature)+b, where a and b are known parameters determined in advance, and the form of this function has also been determined in advance. The real-time prediction would then comprise inputting the current ambient temperature into this function to determine the predicted energy consumption. Different operating modes of cooling units may have different functions associated with them, e.g. with different forms and/or with different parameters.

Determining the form of the functions and/or the parameters of the functions may be performed using regression models. Alternatively or in addition, as the skilled person would understand, machine learning approaches may be used which take the input data and the desired output and calculate the form and the parameters of the function.

In these approaches, the current ambient air temperature used for evaluation may be obtained from one or more of the system controller 206 and the cooling unit controllers 204a, 204b, 204c. One or more temperature sensors may be provided (e.g. coupled to one of or each cooling unit 100, 202a, 202b, 202c), which is configured to measure the ambient air temperature. The temperature sensor(s) may be communicatively coupled to one or more of the above-described controllers and configured to transmit temperature measurements thereto for use in determining predicted energy consumption.

In a step 306, the method 300 comprises generating, in response to determining that the predicted energy consumption is lower than the current energy consumption, a computer-executable instruction configured to cause the plurality of cooling units to operate according to the second configuration.

It may be determined whether/that the predicted energy consumption is lower than the current energy consumption. The computer-executable instruction may be transmitted to at least one of the plurality of cooling units. For example, the computer-executable instruction may be configured to change the operation of at least one of the plurality of cooling units from inactive to active or vice versa and/or to alter the mode of operation of at least one of the cooling units. The computer-executable instruction may only be transmitted to cooling units for which their active/inactive status and/or mode of operation differs between the first configuration and the second configuration, and not to any cooling units for which there is no change between the first configuration and the second configuration. A single computer-executable instruction may be sent to multiple of the cooling units or different computer-executable instructions may be sent to different cooling units.

It may be determined whether a difference between the current energy consumption and the predicted energy consumption is greater than a threshold. The computer-executable instruction may be generated in response to the difference being greater than the threshold and not generated otherwise. Since there may be some overhead associated with changing the configuration of the plurality of cooling units, for example in terms of energy expended and stabilization time, use of this threshold may advantageously prevent changing the configuration for trivial changes in energy consumption. Use of this threshold may also prevent rapid switching of configuration, e.g. back and forth between the first and second configurations, where the energy consumption associated with each of these is very similar.

It may be determined whether a total cooling capacity deliverable by the plurality of cooling units in the second configuration is suitable for cooling a data centre housing the plurality of cooling units. In other words, it may be determined whether the cooling provided by the plurality of cooling units in the second configuration will provide at least the level of cooling currently required by the data centre. The computer-executable instruction may be generated in response to this condition being satisfied. This may ensure that efforts to increase the energy efficiency of the cooling system do not compromise deliverance of the required cooling.

The obtaining of the current energy consumption, the determining of the predicted energy consumption and/or the generating of the computer-executable instruction may be repeated at pre-defined time intervals. Alternatively, or in addition, one or more of these steps may be performed in response to a temperature change above a threshold, or in response to a change in required cooling above a threshold. This may enable dynamic and responsive operation of the cooling system to optimise its energy efficiency in the current operational context.

While (current and predicted) energy consumption are referred to herein, it will be appreciated that these may refer to absolute energy consumptions or energy consumptions as a function of time/for a given unit of time, i.e. to power consumptions. As such, current energy consumption may be used interchangeably with current power consumption herein and predicted energy consumption may be used interchangeably with predicted power consumption herein.

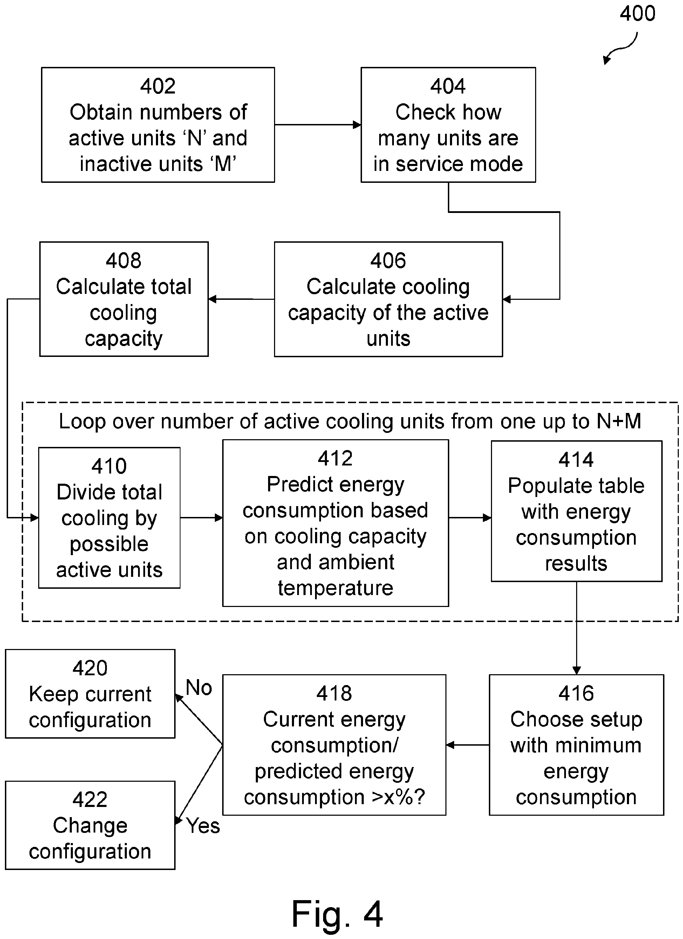

Figure 4 depicts a further example method 400 for optimising operation of a plurality of cooling units according to the present disclosure. The steps of method 400 are combinable with the steps of method 300 described in relation to Figure 3. Similar steps in these methods may be performed in a corresponding manner. The method 400 may be performed by the system controller 206. The method 400 may be performed by one of the cooling unit controllers 204a, 204b, 204c, for example a one of the cooling unit controllers 204a, 204b, 204c which is designated a master cooling unit controller. In some examples, the cooling unit controllers 204a, 204b, 204c may maintain local control duties for the respective cooling units 202a, 202b, 202c, while the system controller 206 may perform, on a supervisory level, the computationally more heavy operation and handle communication/information pulling/data collection from the cooling unit controllers 204a, 204b, 204c.

The controller 206, 204a, 204b, 204c may comprise a processor and a memory storing computer-executable instructions, the instructions when executed causing the processor to perform the method 400. The instructions may be stored in a computer-readable medium.

For the method 400, consider a total number of cooling units N + M installed in a data centre. N units are designated as active units and M units are designated as inactive units (e.g. in standby mode), e.g. to provide redundancy in case of failure.

In a step 402, the method may comprise obtaining the numbers 'N' and 'M'. For example, these may be obtained based on accessing a database in which the current status of each of the N + M cooling units is stored. In another example, these may be obtained by sending respective electronic messages querying the statuses of each of the cooling units, and obtaining the statuses from the responses. In a step 404, the method may comprise checking how many units are in service mode, are undergoing maintenance or are otherwise unusable. These may be removed/subtracted from the total number of units N + M and may not be considered in the further steps of the method.

In a step 406, the method may comprise calculating the respective cooling capacity of each of the active cooling units. As would be understood by the skilled person, this may be determined in various different ways. For example, this may be computed based on a mathematical model of the units, or may be calculated using one or more physical devices such as enthalpy flowmeters. As would be understood by the skilled person, the cooling capacity of a cooling unit corresponds to the amount of heat the cooling unit can remove from the cooled space over time. As used herein, the cooling capacity may refer the amount of cooling a cooling unit is currently delivering, which may be a fraction of the maximum potential cooling capacity of the cooling unit. The cooling capacity can be determined by multiplying the mass of the refrigerant by the specific heat capacity of the refrigerant by the change in temperature of the refrigerant. As such, the cooling capacity may be calculated based on measurements by temperature sensors and flow meters of each cooling unit. In some examples, the cooling capacity may be determined based on look-up tables for particular models of cooling units operating in particular operating conditions. The cooling capacity may be computed by measuring parameters of the air and computing the cooling capacity based on these using a mathematical model. Alternatively, or in addition, the cooling capacity may be computed by measuring parameters of the refrigerant and computing the cooling capacity based on these using a mathematical model.

In a step 408, the method may comprise calculating the total cooling capacity of the cooling system, i.e. of the N active cooling units. This may be calculated by summing the cooling capacities of each of the active cooling units as calculated in step 406.

Steps 410, 412 and 414 may be performed in a loop for numbers of active cooling units from 1 to N + M. In other words, steps 410, 412 and 414 may be performed considering the situation in which one of the units is active, two of the units are active, etc, until the situation is considered in which all of the N + M units are active. For the N currently active cooling units, this may include considering the situation in which one of the inactive (standby) units is activated, in which two of the inactive (standby) units are activated, etc, until the situation is considered in which all of the N + M units are active. For the consideration of numbers of active units lower than N, i.e. consideration of situations in which fewer units are active than are currently active, this may include a consideration of deactivating one or more of the currently active units. This may lead to lower energy consumption in some scenarios and is encompassed within the present disclosure. In other words, in some operational situations, activating additional unit(s) may be determined to lower the total energy consumption of the system of cooling units, but in other operational situations it may be beneficial rather to turn off (deactivate) cooling unit(s) to decrease the total energy consumption on the system level.

In the step 410, the total cooling capacity may be divided by the number of possible active units (i.e. by 1 in the first iteration, 2 in the second iteration, etc). In the step 412, the energy consumption of the active cooling units may be predicted, which may be based on the cooling capacity and the ambient temperature. As described above, the cooling system controller 206 may be configured to receive measurements from each of the cooling units such as temperatures, pressures, ramping, opening, etc. The system controller 206 may thereby calculate the cooling capacity of each of the cooling units and, based on the cooling capacity and ambient temperature, predict the energy consumption of each of the cooling units. As described herein, the predicted energy consumption may be based on one or more of the active cooling units operating in a particular operating mode, which may differ from the operating mode of the current configuration. In the step 414, the method may comprise populating a table with the results of step 412. The table may be stored in a database/in a memory. Each row of the table may indicate one or more of the cooling capacity, the number of active units considered, the predicted energy consumption and the cooling mode(s) in respective columns of the table.

In a step 416, it may be determined which configuration (i.e. which row of the table) was associated with the lowest energy consumption. In a step 418, the current energy consumption may be compared to the predicted energy consumption of the chosen/determined configuration, and it may be determined whether these differ by more than a threshold amount (e.g. a number of kW or kWh) or by a threshold percentage. For example, the current energy consumption may be divided by the predicted energy consumption, or the predicted energy consumption may be subtracted from the current energy consumption. If the difference is not greater than the threshold, the method may continue to step 420 in which the current configuration is maintained. If the difference is greater than the threshold, the method may continue to step 422 in which the configuration is changed to the chosen configuration determined in step 416. A control signal may be generated and transmitted to one or more of the cooling units to effect an activation sequence. In the activation sequence, the cooling unit(s) may be activated, the process may pause for a predetermined period as operation of the cooling unit(s) stabilises, and then the instructed cooling mode may be implemented.

The method 400 may be repeated periodically, for example once per hour. Alternatively, or in addition, the method 400 may be implemented in response to determination of a change, such as a change to the number of cooling units being serviced, a change to the required cooling above a threshold or a change to the ambient temperature above a second threshold.

The table may be stored in an accessible form to provide a lookup table for future iterations of the method 400. This may avoid the need to repeat all the calculations of method 400 each time, and therefore increase the speed and efficiency of performance of the method.

By way of non-limiting example, a cooling system including four cooling units may be considered. Two of the cooling units may be operating in compressor mode and the remaining two cooling units may be in standby mode. By applying the methods described herein, it may be determined that an activation of one of the units currently in standby mode may make it possible to run the three active units in mixed mode and still have adequate cooling capacity to deliver the required cooling. Alternatively, or in addition, it may be determined by applying the methods described herein that an activation of both of the units in standby mode may make it possible to run the four active units in pump mode and still have adequate cooling capacity to deliver the required cooling. The configuration which has the lowest energy consumption may be determined and the cooling system may be instructed to operate according to that configuration.

As such, the techniques described herein may be used to determine when and to what extent to make use of cooling units currently in standby mode. The maximum deliverable cooling capacity of the cooling units in the pump mode and mixed mode is a function of the ambient temperature. By splitting the requested cooling demand among more cooling units, the cooling system may be able to operate in pump mode a higher percentage of the time and thereby to operate with reduced average energy consumption. Due to the large difference between energy consumptions of pumps and compressors respectively, operation of a greater number of cooling units in pump mode may be more energy efficient than operation of a smaller number of cooling units in mixed mode, which may in turn be more energy efficient than operation of an even smaller number of cooling units in compressor mode. The techniques of the present disclosure enable increased operation in more energy efficient modes by leveraging redundant cooling units within a cooling system.

The method 400 described above may not require complicated mathematical operations such that it can be performed quickly and efficiently without requiring excessive processing power to implement. However, as a contributing factor to this, the method 400 may be based on an assumption that each of the cooling units performs an equal share of the cooling. In other examples, a full numerical optimisation may be performed to determine an optimised number of active cooling units and the cooling capacity distribution among them, in which the total cooling capacity of the system of cooling units fulfils the demand of the data centre, in which the cooling units are operating within their physical limits and in which the total energy consumption for the system of cooling units is minimised. This may be formulated mathematically as follows:

$$min_{capacity_i, A_i} \sum_{i=1}^{m} M\_energy_i(x) * A_i$$

$$s.t.: \frac{(abs(Req_{load}) - \sum_{i=1}^{m} M\_capacity_i(x,p))}{Req_{load}} \leq z\%$$

$$capacity_{i_{min}} \leq M\_capacity_i(x,p) \leq capacity_{i_{max}}$$

$$\forall i \in \{1, \dots, m\}$$

$$x = (capacity_i)$$

$$p = \begin{pmatrix} T_{RAT} \\ T_{SAT} \\ Tambient \\ evap\,fan \end{pmatrix}$$

$$A_i \in \{0,1\}$$

In these equations, *M_energy* represents a mapping/function of the given cooling unit which takes parameters such as requested capacity and ambient conditions and returns energy consumption. Similarly, *M_capacity* represents a mapping for cooling capacity. The optimisation may be performed such that the cooling capacity delivered is within z% of the required load $Req_{load}$. The changeable variables are the activation $A_i$ (which may be 0 or 1) and *capacity$_i$*, i.e. the cooling capacity it is required to deliver. Parameters such as the ambient conditions (ambient temperature) may be fixed, and it may be assumed that there is no disturbance on an air delivery side of the cooling unit. Fixing of parameters may ensure that the searching space for the optimisation is kept to a feasible size. To further enable this, a maximum and minimum cooling capacity (*capacity$_{imax}$* and *capacity$_{imin}$*) of each cooling unit may also be considered.

Advantageously, this full optimisation is able to consider uneven cooling capacity distribution and may thereby enable determinations of further configurations which may have even lower energy consumption. However, this comes with higher computational cost. To offset this, as described above, calculations may be stored, for example in a look-up table, to be used in future iterations of these techniques. For example, already seen scenarios with particular required cooling, ambient temperature and configuration may be stored. For future iterations of these techniques, it may first be determined if the look up table comprises the situation currently being considered. If so, the result(s) from the look-up table may be used instead of re-solving the optimisation problem.

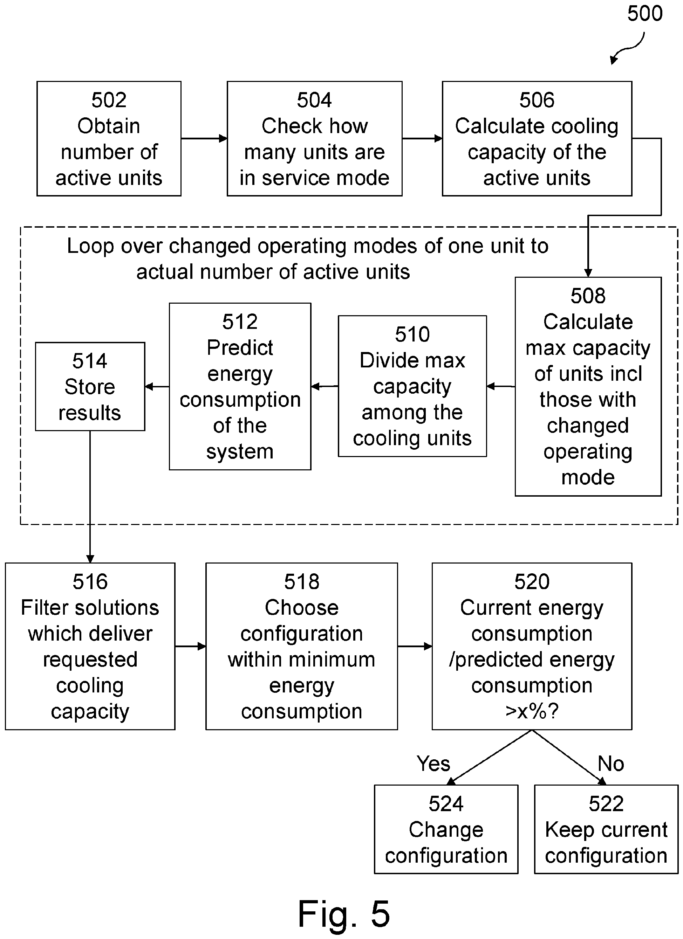

Figure 5 depicts a further example method 500 for optimising operation of a plurality of cooling units according to the present disclosure. The steps of method 500 are combinable with the steps of method 300 described in relation to Figure 3 and/or the steps of method 400 described in relation to Figure 4. Similar steps in these methods may be performed in a corresponding manner. The method 500 may be performed by the system controller 206. The method 500 may be performed by one of the cooling unit controllers 204a, 204b, 204c, for example a one of the cooling unit controllers 204a, 204b, 204c which is designated a master cooling unit controller. The controller 206, 204a, 204b, 204c may comprise a processor and a memory storing computer-executable instructions, the instructions when executed causing the processor to perform the method 500. The instructions may be stored in a computer-readable medium.

While the method 400 of Figure 4 describes a situation in which there may be redundant cooling units in standby mode, the method 500 of Figure 5 may describe a situation in which there are not, or typically are not, redundant cooling units in standby mode. However, in the situation of Figure 5, one or more of the cooling units of the cooling system may be operating with partial load, i.e. may each be operating and providing cooling at less than their full capacity. In other words, the method 500 could be used when there is no redundancy or when further activation/deactivation is not under consideration. Therefore, the number of active cooling units may not be increased/decreased, but instead the operation mode of one or more of the cooling units may be changed if it is determined that this would reduce energy consumption.

In a step 502, the number 'N' of active units may be obtained. In a step 504, it may be determined how many units are in service mode. These steps may be respectively performed in a corresponding manner to steps 402 and 404 described above.

In a step 506, a cooling capacity of the active units may be calculated. This may be performed in a corresponding manner to step 406 described above. The total cooling capacity of all of the cooling units may be determined in a corresponding manner to step 408 described above.

Steps 508, 510, 512 and 514 may be performed in a loop over changed operating modes for numbers of active cooling units from one to N. These steps may be performed considering the situation in which operation of one of the active cooling units is changed to a different mode, two of the active cooling units is changed to the different mode, etc. until considering the situation in which all of the active cooling units are operating in the different mode. Steps 508, 510, 512, 514 may be performed in a loop for numbers of active cooling units from one to N and in a loop over all operating modes. This may comprise consideration of different numbers of cooling units operating in compressor mode, pump mode and/or mixed mode.

In the step 508, the maximum cooling capacity deliverable by the units is calculated. The maximum cooling capacity may be calculated for each of the cooling units, including those for which the mode of operation has changed. The maximum cooling capacity may be calculated based at least in part on the current ambient temperature. The maximum cooling capacity may be determined based on data sheets corresponding to the model of cooling units used, and/or based on previous experimental measurements for the cooling capacity of the cooling units. In the step 510, the maximum capacity of the cooling units from step 508 may be divided among the cooling units. The cooling capacity allocated to the cooling units operating in the changed mode may be smaller or larger than the cooling capacity allocated to the remaining cooling units, for example based on the calculations performed as part of step 508. In the step 512, the energy consumption of the system may be predicted, which may correspond to step 412. In the step 514, the results of step 512, and optionally steps 508 and/or 510, may be stored, which may correspond to step 414.

In a step 516, the method may comprise filtering for solutions which deliver the requested cooling capacity. In other words, configurations which are not capable of providing the requested cooling capacity even when providing their maximum cooling capacity according to step 508 are ignored, negated or removed from the considered configurations.

In a step 518, the configuration (of the filtered configurations) which has the lowest energy consumption is determined and selected, which may correspond to step 416. In a step 520, the current energy consumption is compared to the predicted energy consumption of the configuration with the minimum energy consumption. This comparison may be through division or subtraction and the result is compared to a threshold. This step may correspond to step 418. If the result is not larger than the threshold, the method may proceed to step 522 in which the current configuration is kept, which may correspond to step 420. If the result is larger than the threshold, the method may proceed to step 524 in which the configuration is changed to the configuration with the lowest energy consumption, which may correspond to step 422.

The techniques of the present disclosure enable optimisation on a system wide level through leveraging the flexibility provided by different numbers of cooling units and different operating modes of these cooling units. These are leveraged in a systematic, structured and quantified approach which enables identification of opportunities to change the configuration of the cooling system such that it operates in a more energy efficient manner depending on the current ambient temperature and cooling requirements. Therefore, the techniques of the present disclosure enable more responsive, more dynamic and more energy efficient operation of a cooling system comprising a plurality of cooling units.

While the methods disclosed herein are presented in a certain sequential order, this should not be taken to limit the methods to the orders presented. One or more of the method steps may be omitted or rearranged. The various steps may be performed in different orders. Various steps may be performed at the same time or substantially the same time. Herein, references to events occurring substantially at the same time may refer to events at least partially overlapping in time and/or events occurring at the same time within measurement uncertainties.

The cooling unit(s), cooling system and/or controller(s) described herein may be configured to perform any of the method steps presently disclosed and may comprise computer executable instructions which, when executed by a processor cause the processor to perform any of the method steps presently disclosed, or when executed by the controller(s) cause the controller(s) to perform any of the method steps presently disclosed, or when executed by the cooling unit(s)/cooling system, cause the cooling unit(s)/cooling system to perform any of the method steps presently disclosed. Any of the steps that the cooling unit(s), cooling system and/or controller(s) are configured to perform may be considered as method steps of the present disclosure and may be embodied in computer executable instructions for execution by a processor. A computer-readable medium may comprise the above-described computer executable instructions.

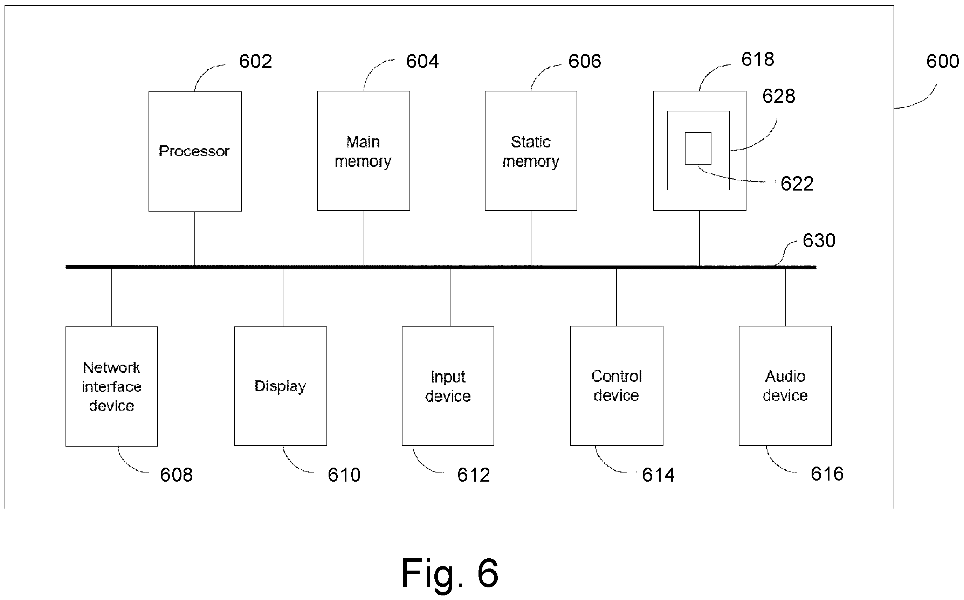

Figure 6 illustrates a block diagram of one implementation of a computing device 600 within which a set of instructions, for causing the computing device to perform any one or more of the methodologies discussed herein, may be executed. In alternative implementations, the computing device may be connected (e.g., networked) to other machines in a Local Area Network (LAN), an intranet, an extranet, or the Internet. The computing device may operate in the capacity of a server or a client machine in a client-server network environment, or as a peer machine in a peer-to-peer (or distributed) network environment. The computing device may be a personal computer (PC), a tablet computer, a set-top box (STB), a Personal Digital Assistant (PDA), a cellular telephone, a web appliance, a server, a network router, switch or bridge, or any machine capable of executing a set of instructions (sequential or otherwise) that specify actions to be taken by that machine. Further, while only a single computing device is illustrated, the term "computing device" shall also be taken to include any collection of machines (e.g., computers) that individually or jointly execute a set (or multiple sets) of instructions to perform any one or more of the methodologies discussed herein. The computing device 600 may correspond to the one or more of the cooling unit controllers 124, 204a, 204b, 204c and/or the cooling system controller 206 as described herein.

The example computing device 600 includes a processing device 602, a main memory 604 (e.g., read-only memory (ROM), flash memory, dynamic random access memory (DRAM) such as synchronous DRAM (SDRAM) or Rambus DRAM (RDRAM), etc.), a static memory 606 (e.g., flash memory, static random access memory (SRAM), etc.), and a secondary memory (e.g., a data storage device 618), which communicate with each other via a bus 630.

Processing device 602 represents one or more general-purpose processors such as a microprocessor, central processing unit, or the like. More particularly, the processing device 602 may be a complex instruction set computing (CISC) microprocessor, reduced instruction set computing (RISC) microprocessor, very long instruction word (VLIW) microprocessor, processor implementing other instruction sets, or processors implementing a combination of instruction sets. Processing device 602 may also be one or more special-purpose processing devices such as an application specific integrated circuit (ASIC), a field programmable gate array (FPGA), a digital signal processor (DSP), network processor, or the like. Processing device 602 is configured to execute the processing logic (instructions 622) for performing the operations and steps discussed herein.

The computing device 600 may further include a network interface device 608. The computing device 60 also may include a video display unit 610 (e.g., a liquid crystal display (LCD) or a cathode ray tube (CRT)), an alphanumeric input device 612 (e.g., a keyboard or touchscreen), a cursor control device 614 (e.g., a mouse or touchscreen), and an audio device 616 (e.g., a speaker).

The data storage device 618 may include one or more machine-readable storage media (or more specifically one or more non-transitory computer-readable storage media) 628 on which is stored one or more sets of instructions 622 embodying any one or more of the methodologies or functions described herein. The instructions 622 may also reside, completely or at least partially, within the main memory 604 and/or within the processing device 602 during execution thereof by the computer system 600, the main memory 604 and the processing device 602 also constituting computer-readable storage media.

The various methods described above may be implemented by a computer program. The computer program may include computer code arranged to instruct a computer to perform the functions of one or more of the various methods described above. The computer program and/or the code for performing such methods may be provided to an apparatus, such as a computer, on one or more computer readable media or, more generally, a computer program product. The computer readable media may be transitory or non-transitory. The one or more computer readable media could be, for example, an electronic, magnetic, optical, electromagnetic, infrared, or semiconductor system, or a propagation medium for data transmission, for example for downloading the code over the Internet. Alternatively, the one or more computer readable media could take the form of one or more physical computer readable media such as semiconductor or solid state memory, magnetic tape, a removable computer diskette, a random access memory (RAM), a read-only memory (ROM), a rigid magnetic disc, and an optical disk, such as a CD-ROM, CD-R/W or DVD.

In an implementation, the modules, components and other features described herein can be implemented as discrete components or integrated in the functionality of hardware components such as ASICS, FPGAs, DSPs or similar devices.

A "hardware component" is a tangible (e.g., non-transitory) physical component (e.g., a set of one or more processors) capable of performing certain operations and may be configured or arranged in a certain physical manner. A hardware component may include dedicated circuitry or logic that is permanently configured to perform certain operations. A hardware component may be or include a special-purpose processor, such as a field programmable gate array (FPGA) or an ASIC. A hardware component may also include programmable logic or circuitry that is temporarily configured by software to perform certain operations.

Accordingly, the phrase "hardware component" should be understood to encompass a tangible entity that may be physically constructed, permanently configured (e.g., hardwired), or temporarily configured (e.g., programmed) to operate in a certain manner or to perform certain operations described herein.

In addition, the modules and components can be implemented as firmware or functional circuitry within hardware devices. Further, the modules and components can be implemented in any combination of hardware devices and software components, or only in software (e.g., code stored or otherwise embodied in a machine-readable medium or in a transmission medium).

Unless specifically stated otherwise, as apparent from the following discussion, it is appreciated that throughout the description, discussions utilizing terms such as " receiving", "determining", "comparing ", "enabling", "maintaining," "identifying," "adjusting, " "transmitting," "generating," "operating," "obtaining," or the like, refer to the actions and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

The approaches described herein may be embodied on a computer-readable medium, which may be a non-transitory computer-readable medium. The computer-readable medium may carry computer-readable instructions arranged for execution upon a processor so as to cause the processor to carry out any or all of the methods described herein.

The term "computer-readable medium" as used herein refers to any medium that stores data and/or instructions for causing a processor to operate in a specific manner. Such storage medium may comprise non-volatile media and/or volatile media. Non-volatile media may include, for example, optical or magnetic disks. Volatile media may include dynamic memory. Exemplary forms of storage medium include, a floppy disk, a flexible disk, a hard disk, a solid state drive, a magnetic tape, or any other magnetic data storage medium, a CD-ROM, any other optical data storage medium, any physical medium with one or more patterns of holes, a RAM, a PROM, an EPROM, a FLASH-EPROM, NVRAM, and any other memory chip or cartridge.

It is to be understood that the above description is intended to be illustrative, and not restrictive. Many other implementations will be apparent to those of skill in the art upon reading and understanding the above description.

Although the present disclosure has been described with reference to specific example implementations, it will be recognized that the disclosure is not limited to the implementations described, but can be practiced with modification and alteration within the scope of the appended claims. Accordingly, the specification and drawings are to be regarded in an illustrative sense rather than a restrictive sense. The scope of the disclosure should, therefore, be determined with reference to the appended claims, along with the full scope of equivalents to which such claims are entitled.

**Claims**

1. A method for optimising operation of a plurality of cooling units, the method comprising:

   obtaining a current energy consumption of a first configuration of the plurality of cooling units in which a first number of the plurality of cooling units are active;
   determining a predicted energy consumption of a second configuration of the plurality of cooling units in which a second number of the plurality of cooling units are active, and in which one or more of the second number of the plurality of cooling units operates in an altered mode of operation relative to the first configuration; and
   generating, in response to determining that the predicted energy consumption is lower than the current energy consumption, a computer-executable instruction configured to cause the plurality of cooling units to operate according to the second configuration.

2. A method according to claim 1, comprising transmitting the computer-executable instruction to at least one of the plurality of cooling units.

3. A method according to claim 1 or claim 2, comprising:

   determining whether a difference between the current energy consumption and the predicted energy consumption is greater than a threshold; and
   generating the computer-executable instruction in response to determining the difference is greater than the threshold.

4. A method according to any preceding claim, wherein the second number of the plurality of cooling units active in the second configuration is greater than the first number of the plurality of cooling units active in the first configuration.

5. A method according to any preceding claim, wherein the second number of the plurality of cooling units active in the second configuration is smaller than the first number of the plurality of cooling units active in the first configuration.

6. A method according to any preceding claim, wherein the altered mode of operation is selected from a pump mode of operation, a compressor mode of operation and a mixed pump and compressor mode of operation.

7. A method according to any preceding claim, wherein the determining the predicted energy consumption comprises determining, for each of a plurality of candidate second configurations, a respective predicted energy consumption, each of the plurality of candidate second configurations having a different respective number of the plurality of cooling units active and/or a different respective altered mode of operation.

8. A method according to claim 7, comprising determining which of the plurality of candidate second configurations has a smallest predicted energy consumption and selecting that candidate second configuration as the second configuration.

9. A method according to claim 7 or claim 8, comprising storing the plurality of candidate second configurations and the respective predicted energy consumptions in a database.

10. A method according to any preceding claim, wherein the determining the predicted energy consumption is based on a current ambient temperature.

11. A method according to any preceding claim, comprising repeating the obtaining of the current energy consumption, the determining of the predicted energy consumption, and/or the generating of the computer-executable instruction at pre-defined time intervals.

12. A method according to any preceding claim, comprising determining whether a total cooling capacity deliverable by the plurality of cooling units in the second configuration is suitable for cooling a data centre housing the plurality of cooling units.

13. A control device comprising a processor and a memory storing computer-executable instructions, the instructions when executed causing the processor to perform the method of any preceding claim.

14. A cooling system comprising:

>   the control device of claim 13; and
>   the plurality of cooling units.

15. A computer-readable medium storing instructions which, when executed by a processor, cause performance of the method of any of claims 1-12.

Fig. 1

202a

200

204a

202b

204b

206

202c

204c

Fig. 2

300

302
Obtain a current energy consumption of a first configuration of a plurality of cooling units in which a first number of the plurality of cooling units are active

304
Determine a predicted energy consumption of a second configuration of the plurality of cooling units in which a second number of the plurality of cooling units are active, and in which one or more of the second number of the plurality of cooling units operates in an altered mode of operation relative to the first configuration

306
Generate, in response to determining that the predicted energy consumption is lower than the current energy consumption, a computer-executable instruction configured to cause the plurality of cooling units to operate according to the second configuration

Fig. 3

400

```
┌─────────────────────┐      ┌─────────────────────┐
│        402          │      │        404          │
│  Obtain numbers of  │─────▶│    Check how        │
│  active units 'N' and│     │  many units are     │
│  inactive units 'M' │      │  in service mode    │
└─────────────────────┘      └─────────────────────┘
                                        │
                                        ▼
┌─────────────────────┐      ┌─────────────────────┐
│        408          │      │        406          │
│  Calculate total    │◀─────│  Calculate cooling  │
│     cooling         │      │ capacity of the active│
│    capacity         │      │      units          │
└─────────────────────┘      └─────────────────────┘
```

```
┌ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┐
  Loop over number of active cooling units from one up to N+M
│ ┌──────────────┐   ┌──────────────────┐   ┌──────────────┐      │
    │     410      │   │       412        │   │     414      │
│ │  Divide total │   │  Predict energy  │   │ Populate table│     │
    │  cooling by  │──▶│ consumption based│──▶│  with energy │
│ │   possible    │   │  on cooling capacity│ │ consumption  │     │
    │ active units │   │   and ambient    │   │   results    │
│ └──────────────┘   │   temperature    │   └──────────────┘      │
                     └──────────────────┘
└ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┘
                                                      │
                                                      ▼
┌──────────────┐         ┌──────────────────┐   ┌──────────────┐
│     420      │   No    │       418        │   │     416      │
│ Keep current │◀────────│  Current energy  │◀──│ Choose setup │
│configuration │         │  consumption/    │   │ with minimum │
└──────────────┘         │ predicted energy │   │   energy     │
                         │ consumption >x%? │   │ consumption  │
┌──────────────┐         └──────────────────┘   └──────────────┘
│     422      │   Yes
│   Change     │◀────
│configuration │
└──────────────┘
```

# Fig. 4

Fig. 5

Fig. 6

Europäisches
Patentamt

European
Patent Office

Office européen
des brevets

# EUROPEAN SEARCH REPORT

**Application Number**

EP 24 17 3082

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/278070 A1 (BASH CULLEN E [US] ET AL) 15 December 2005 (2005-12-15) * paragraph [0019] - paragraph [0021]; claims 1,2,32,35 * * paragraphs [0060], [0073] * * paragraph [0090] - paragraph [0091] * ----- | 1-15 | INV. H05K7/20 G06F1/20 G06F1/3206 G06F1/3234 |
| X | US 2013/110306 A1 (WANG ZHIKUI [US] ET AL) 2 May 2013 (2013-05-02) * paragraph [0014] - paragraph [0016] * * paragraph [0036]; figure 3 * * paragraph [0049] - paragraph [0056]; claims 1,7,10,11; figure 5b * ----- | 1-15 | |
| A | EP 2 755 461 A2 (LIEBERT CORP [US]) 16 July 2014 (2014-07-16) * paragraph [0075] - paragraph [0076] * ----- | 6 | |
| A | US 10 180 261 B1 (ROSS PETER GEORGE [US] ET AL) 15 January 2019 (2019-01-15) * column 7, line 67 - column 8, line 7 * ----- | 11 | TECHNICAL FIELDS SEARCHED (IPC) H05K G06F |

The present search report has been drawn up for all claims

| Place of search | Date of completion of the search | Examiner |
|---|---|---|
| The Hague | 14 October 2024 | Schröter, Marcel |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 17 3082

This annex lists the patent family members relating to the patent documents cited in the above-mentioned European search report.
The members are as contained in the European Patent Office EDP file on
The European Patent Office is in no way liable for these particulars which are merely given for the purpose of information.

14-10-2024

| Patent document cited in search report | | Publication date | Patent family member(s) | | Publication date |
|---|---|---|---|---|---|
| US 2005278070 | A1 | 15-12-2005 | CN | 101023718 A | 22-08-2007 |
| | | | US | 2005278070 A1 | 15-12-2005 |
| | | | WO | 2005120145 A1 | 15-12-2005 |
| US 2013110306 | A1 | 02-05-2013 | NONE | | |
| EP 2755461 | A2 | 16-07-2014 | CN | 103609206 A | 26-02-2014 |
| | | | CN | 103884050 A | 25-06-2014 |
| | | | CN | 103884125 A | 25-06-2014 |
| | | | CN | 103884139 A | 25-06-2014 |
| | | | EP | 2700289 A2 | 26-02-2014 |
| | | | EP | 2755461 A2 | 16-07-2014 |
| | | | EP | 3094167 A1 | 16-11-2016 |
| | | | ES | 2788127 T3 | 20-10-2020 |
| | | | ES | 2807357 T3 | 22-02-2021 |
| | | | HR | P20200699 T1 | 16-10-2020 |
| | | | HR | P20201361 T1 | 11-12-2020 |
| | | | US | 2013098085 A1 | 25-04-2013 |
| | | | US | 2015230367 A1 | 13-08-2015 |
| | | | WO | 2012145263 A2 | 26-10-2012 |
| US 10180261 | B1 | 15-01-2019 | NONE | | |

EPO FORM P0459

For more details about this annex : see Official Journal of the European Patent Office, No. 12/82